Europäisches Patentamt

European Patent Office

Office européen des brevets

(19)

(11) Veröffentlichungsnummer : **0 051 166**
**B1**

(12) # EUROPÄISCHE PATENTSCHRIFT

(45) Veröffentlichungstag der Patentschrift :
03.04.85

(21) Anmeldenummer : 81108142.1

(22) Anmeldetag : 09.10.81

(51) Int. Cl.⁴ : **G 03 F 7/26**

(54) **Verfahren für die spannungsfreie Entwicklung von bestrahlten Polymethylmethacrylatschichten.**

(30) Priorität : 16.10.80 DE 3039110

(43) Veröffentlichungstag der Anmeldung :
**12.05.82 Patentblatt 82/19**

(45) Bekanntmachung des Hinweises auf die Patenterteilung : **03.04.85 Patentblatt 85/14**

(84) Benannte Vertragsstaaten :
**FR GB NL**

(56) Entgegenhaltungen :
**Römpps Chemie - Lexikon (1979), S. 347**

(73) Patentinhaber : **Siemens Aktiengesellschaft
Berlin und München Wittelsbacherplatz 2
D-8000 München 2 (DE)**

(72) Erfinder : **Glashauser, Walter
Paul-Klee-Strasse 4
D-8000 München 71 (DE)**
Erfinder : **Ghica, Grigore-Vlad, Dipl.-Ing.
Lechnerstrasse 31
D-8026 Ebenhausen (DE)**

## Beschreibung

Die Erfindung betrifft ein Verfahren zur Erzeugung von rißfreien Strukturen in röntgen- oder elektronenstrahlempfindlichen Lackschichten oder -folien, z. B. PMMA, zur Erreichung eines sehr hohen Aspektverhältnisses nach einer sachgerechten Bestrahlung und der restlosen Entfernung der auf den Strukturen und freientwickelten Flächen verbliebenen aber gelösten Rückstände. Mit PMMA ist Polymethylmethacrylat bezeichnet, das bei der Röntgenlithografie bevorzugt als Resistmaterial eingesetzt wird.

Bei der Herstellung von integrierten Schaltkreisen und Bauelementen für Oberflächenwellen und Mikrowellen werden sehr feine Strukturen mit Abmessungen im Mikron- und Submikronbereich benötigt. Für die Strukturerzeugung sind hierbei vor allem Reproduktionstechniken, wie die Elektronenlithografie oder die Röntgenlithografie interessant, da sie mit wesentlich kürzeren Wellenlängen als die herkömmliche Fotolithografie arbeiten und somit ein besseres Auflösungsvermögen aufweisen. Kennzeichnend für diese Anwendungsart der Röntgenlithografie sind Maskierschichtdicken bis zu ca. 3 $\mu$m. Diese Schichtdicken reichen in der Regel für die anschließenden Arbeitsschritte wie Ätzen, Bedampfen usw. aus.

Eine weitere Anwendungsmöglichkeit der Röntgenlithografie ist das galvanische Erzeugen flacher Metallformteile mit extrem kleinen Strukturabmessungen. Hierbei muß die Abdeckschicht, die das galvanisch abgeschiedene Metall seitlich begrenzt, eine etwas größere Schichtdicke aufweisen als das abgeformte Teil. Das Ziel dieser Technik ist, bei möglichst dicken Abdeckschichten (größer 100 $\mu$m) senkrechte Flanken in den freientwickelten Partien bei möglichst kleinen Strukturabmessungen zu erreichen.

Eine der Hauptschwierigkeiten für die industrielle Anwendung der Röntgenlithografie bei der Erzeugung von galvanisch abgeschiedenen Flachteilen liegt in der Herstellung rißfreier Abdeckschichten. Bei der Verwendung von PMMA als Abdeckschicht haben Versuche gezeigt, daß bereits ab einer PMMA-Schichtdicke von ca. 3 $\mu$m Spannungsrisse in der Schicht nach der Entwicklung in Erscheinung treten.

Eine weitere Schwierigkeit allgemeiner Art ist, daß auch die unbestrahlten Bereiche der PMMA-Schicht während der Entwicklung teilweise abgetragen werden. Dies führt zu einer Verringerung der Strukturauflösung und somit zu einer Verkleinerung des Aspektverhältnisses.

Der Erfindung liegt die Aufgabe zugrunde, ein Verfahren zur Erzeugung von spannungsfreien Strukturen in röntgen- oder elektronenstrahlempfindlichen eines sehr hohen Aspektverhältnisses PMMA-Lackschichten oder -freien zur Erreichung nach einer sachgerechten Bestrahlung anzugeben. Diese Aufgabe wird dadurch gelöst, daß ein Entwickler gemisch verwendet wird, zusammengesetzt aus einem Glykoläther, insbesondere Äthylenglykol-mono-butyläther oder Diäthylenglykol-mono-butyläther, einem primären Amin, insbesondere Monoäthanolamin, Wasser und einem Oxazin, insbesondere Tetrahydro-1,4-Oxazin.

Mit einem derartigen Entwickler können rißfreie Strukturen mit extrem hohem Aspektverhältnis erzeugt werden. Selbst bei langer Entwicklungszeit, z. B. 16 Stunden, erfolgt kein Abtrag des unbestrahlten Materials ( = Dunkelabtrag). Für eine 100 $\mu$m dicke PMMA-Schicht ist, bei sachgerechter Bestrahlung vorausgesetzt, eine Entwicklungszeit von ca. 20 Minuten erforderlich.

Ein weiterer Vorteil des erfindungsgemäßen Entwicklers ist die rückstandsfreie Entfernbarkeit der gelösten PMMA-Anteile durch kräftiges Spülen, z. B. mit Wasser. Mit dem Entwickler werden die mechanischen Eigenschaften der PMMA-Schicht während der Entwicklung so beeinflußt, daß keine Spannungsrisse mehr entstehen.

Nach einer Weiterbildung der Erfindung besteht der Entwickler aus 50-70 Vol.% Äthylenglykol-mono-butyläther oder Diäthylen-mono-butyläther, 1-20 Vol.% Monoäthanolamin, bis 20 Vol.% Wasser und 5-20 Vol.% Tetrahydro-1,4-Oxazin.

Mit der Entwicklertemperatur können die mechanischen Eigenschaften von PMMA gezielt weiter beeinflußt werden. Nach einer Weiterbildung der Erfindung liegt die optimale Entwicklungstemperatur zwischen 20° und 50 °C.

Die Lösung nach der Erfindung ist sowohl für Tauch- als auch für Sprühentwicklung geeignet. Ein besonderer Vorteil liegt darin begründet, daß der Entwickler wasserlöslich ist und dadurch auf dem beobachteten Substrat beim Spülen mit Wasser keine Rückstände von entwickelten Lackteilen verbleiben. Bei der Herstellung von Matrizen für Galvanoplastikteile wurde mit einem Entwickler nach der Erfindung in 100 $\mu$m dicken PMMA-Schichten ein Aspektverhältnis von 30 : 1 erreicht, ohne daß ein Dunkelabtrag beobachtet werden konnte.

## Ansprüche

1. Verfahren zur Erzeugung von spannungsfreien Strukturen in röntgen- oder elektronenstrahlempfindlichen PMMA-Lackschichten oder -folien zur Erreichung eines sehr hohen Aspektverhältnisses nach einer sachgerechten Bestrahlung, dadurch gekennzeichnet, daß ein Entwickler gemisch verwendet wird, zusammengesetzt aus einem Glykoläther, insbesondere Äthylenglykol-mono-butyläther oder Diäthylenglykol-mono-butyläther, einem primären Amin, insbesondere Monoäthanolamin, Wasser und einem Oxazin, insbesondere Tetrahydro-1,4-Oxazin.

2. Verfahren nach Anspruch 1, dadurch gekennzeichnet, daß ein aus 50-70 Vol.% Äthylenglykol-mono-butyläther oder Diäthylenglykol-mono-butyläther, 1-20 Vol.% Monoäthanolamin, bis 20 Vol.% Wasser und 5-20 Vol.% Tetrahydro-1,4-Oxazin bestehender Entwickler verwendet wird.

3. Verfahren nach Anspruch 1 oder 2, dadurch gekennzeichnet, daß die optimale Entwicklungstemperatur zwischen 20° und 50 °C liegt.

## Claims

1. A process for the production of stress-free structures in X-ray or electron beam-sensitive PMMA lacquer layers or films in order to achieve a very high aspect ratio after suitable irradiation, characterised in that a developer mixture is used which is composed of a glycolether, in particular, ethylene glycol monobutyl ether or diethylene glycol monobutyl ether, a primary amine, in particular monoethanolamine, water and an oxazine, in particular, tetrahydro-1.4-oxazine.

2. A process as claimed in Claim 1, characterised in that a developer is used which consists of 50-70 vol.% ethylene glycol monobutyl ether, or diethylene glycol monobutyl ether, 1-20 vol.% monoethanolamine, up to 20 vol.% water and 5-20 vol.% tetrahydro-1.4-oxazine.

3. A process as claimed in Claim 1 or Claim 2, characterised in that the optimum development temperature lies between 20° and 50 °C.

## Revendications

1. Procédé de fabrication de structures exemptes de tension dans des couches ou des feuilles de vernis en PMMA sensibles aux rayons X ou à un faisceau d'électrons pour obtenir un rapport d'aspect très élevé après une exposition convenable, caractérisé en ce qu'il consiste à utiliser un mélange de révélateur composé d'un éther de glycol, notamment de l'éther monobutylique de l'éthylène glycol ou de l'éther monobutylique du diéthylèneglycol, d'une amine primaire, notamment de la monoéthanolamine, de l'eau et d'une oxazine, notamment de la tétrahydro-1,4-oxazine.

2. Procédé suivant la revendication 1, caractérisé en ce qu'il consiste à utiliser un révélateur constitué de 50 à 60 % en volume de l'éther monobutylique de l'éthylèneglycol ou de l'éther monobutylique du diéthylèneglycol, de 1 à 20 % en volume de monoéthanolamine, jusqu'à 20 % en volume d'eau et de 5 à 20 % en volume de tétrahydro-1,4-oxazine.

3. Procédé suivant la revendication 1 ou 2, caractérisé en ce que la température optimale de développement est comprise entre 20 °C et 50 °C.